# FASCICULE DE BREVET EUROPEEN

(11) **EP 1 683 330 B1**
(45) Date de publication et mention de la délivrance du brevet: **27.06.2007**
(21) Numéro de dépôt: 04805789.7
(22) Date de dépôt: 28.10.2004
(51) Int. Cl.: H04M 1/02

(54) **BOITIER DE TELEPHONE MOBILE**
MOBILTELEFON-HÜLLE
MOBILE TELEPHONE CASE

(30) Priorité: 12.11.2003 FR 0350825
(43) Date de publication de la demande: 26.07.2006
(73) Titulaire: SAGEM Communication, 75015 Paris (FR)
(72) Inventeur: KERBRAT, Patrick, F-95490 Vaureal (FR); PERRA, Nicolas, F-95430 Auvers sur Oise (FR); ROBERT, Stéphane, F-95800 Courdimanche (FR)
(74) Mandataire: Schmit, Christian Norbert Marie
(86) Numéro de dépôt international: PCT/FR2004/050546
(87) Numéro de publication internationale: WO 2005/048566

(56) Documents cités:
- EP-A- 0 707 293
- EP-A- 1 331 796
- DE-C- 3 708 174
- DE-U- 20 113 206

## Description

### DOMAINE TECHNIQUE DE L'INVENTION

La présente invention a pour objet un boîtier de téléphone mobile. Plus particulièrement, l'invention propose un boîtier de téléphone mobile composé essentiellement de trois pièces distinctes, de nature différente, qui sont destinées à être mécaniquement assemblées pour enfermer et supporter un ensemble de composants, notamment électroniques, présents dans les téléphones mobiles. Le boîtier selon l'invention est une coque qui n'est pas destinée à être fréquemment démontée ; elle n'est donc a priori pas destinée à recevoir d'éléments de type batterie de téléphone ou cartes SIM, mais plutôt à recevoir des éléments de type composants électroniques ou écran LCD.

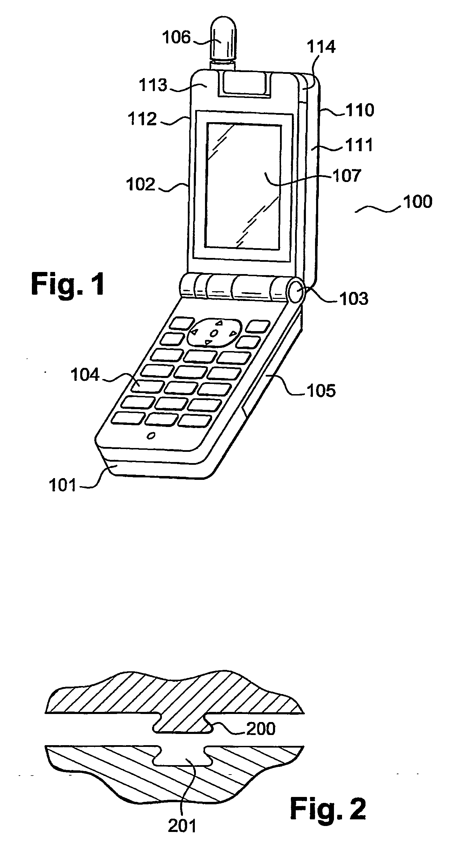

Le domaine de l'invention est donc, d'une façon générale, celui des téléphone mobiles, et notamment, mais pas uniquement, celui des téléphones mobiles, dits clam, du type de celui représenté à la figure 1. Sur cette figure, un téléphone mobile 100 présente un boîtier composé d'une partie basse 101 et d'une partie haute 102 complémentaire. La partie basse 101 est mobile par rapport à la de la partie haute 102 grâce à la présence d'une charnière 103.

Typiquement, la partie basse 101 comporte un clavier 104, et renferme une batterie amovible 105 ou encore une carte SIM non représentée. La conception de la partie basse du boîtier doit donc prendre en considération le fait qu'un utilisateur procédera fréquemment à des opérations d'ouverture/fermeture de la partie basse. Différents mécanismes de translation des pièces mécaniques intervenant doivent être prévus à cet effet.

La partie haute 102 supporte généralement au moins une antenne 106 et, pour les modèles haut de gamme, un écran de type LCD 107; d'autres équipements, du type caméra, peuvent également être prévus dans la partie haute 102. La particularité de la partie haute 102 est que l'utilisateur n'a a priori pas à accéder à l'intérieur du boîtier la constituant. Aucun mécanisme d'ouverture immédiate n'est donc à prévoir dans la conception du boîtier constituant la partie haute 102. L'objet de l'invention est un boîtier de téléphone mobile qui est parfaitement adapté pour être utilisé comme partie haute d'un téléphone mobile de type clam, mais qui pourrait également être utilisé pour d'autres types de téléphones mobiles pour lesquels un accès au contenu du boîtier n'est pas une priorité.

### ARRIERE-PLAN TECHNOLOGIQUE DE L'INVENTION

Un boîtier du type de celui utilisé pour servir de partie haute 102 doit satisfaire différentes exigences : il doit tout d'abord présenter une bonne tenue mécanique pour pouvoir supporter la présence d'une charnière et les contraintes mécaniques qui en résultent ; il doit de plus être relativement complexe dans sa structure interne, un ensemble de composants électroniques sensibles devant y être disposés et maintenus dans un espace aussi réduit que possible. Il doit enfin présenter des caractéristiques esthétiques suffisantes pour séduire un acheteur potentiel du téléphone mobile, et ne pas pénaliser le téléphone en terme de poids.

Pour répondre à l'ensemble de ces contraintes, on a proposé, dans l'état de la technique, d'utiliser trois pièces distinctes, réalisées dans trois matériaux différents ; les propriétés naturelles de chaque matériau utilisé permettent de répondre plus particulièrement à une des contraintes. Par exemple, on utilise :
- une première pièce en aluminium, qui présente un aspect esthétique agréable ;
- une deuxième pièce en plastique, qui présente l'avantage d'être facile à mouler si bien que l'on peut facilement obtenir une pièce complexe susceptible de servir de support aux différents composants électroniques présents au sein du boîtier ; une pièce en plastique est par ailleurs plus élastique que les pièces métalliques, ce qui facilite la mise en place des composants ;
- une troisième pièce en magnésium, qui, outre le fait d'être léger, présente l'avantage d'avoir des propriétés mécaniques suffisantes pour supporter, par exemple, les contraintes mécaniques dues à la présence de la charnière ; le magnésium est par ailleurs relativement facile à usiner.

Ainsi, en se référant toujours à la figure 1, la partie haute 102 est composée :
- d'une première pièce 110 en aluminium formant partie supérieure du boîtier : lorsque le clam est fermé, c'est essentiellement cette pièce qui est visible. La première pièce 110 est essentiellement constituée d'une paroi principale de forme rectangulaire, non visible à la figure 1, et d'une paroi latérale 111 ;
- d'une deuxième pièce en plastique, non visible à la figure 1, formant partie centrale du boîtier ; elle est contenue dans l'épaisseur du boîtier 102 ;
- d'une troisième pièce 112 en magnésium, servant notamment de support à l'écran LCD 107 et à la charnière 103. Elle présente également une paroi principale 113 de forme rectangulaire et une paroi latérale 114 perpendiculaire à cette paroi principale.

Des problèmes d'assemblage de ces trois pièces se posent cependant dans l'état de la technique : en effet, dans les solutions existantes, la pièce en plastique est adhésivée sur la pièce en aluminium et la pièce en magnésium est fixée sur la pièce en plastique. On n'obtient donc pas de réelle coopération entre les trois pièces, la pièce en magnésium étant solidarisée à la pièce en aluminium uniquement par l'intermédiaire de la pièce en plastique. Les conséquences néfastes d'un tel montage sont les suivantes :
- les zones où la pièce en plastique et la pièce en aluminium se superposent sont peu nombreuses, d'une par parce qu'un maximum d'évidements sont ménagés sur la pièce en plastique pour limiter l'épaisseur totale du boîtier, et d'autre part parce qu'il est particulièrement délicat d'utiliser les parois latérales pour une opération de collage ;
- l'utilisation d'un adhésif double face pour rendre solidaire la pièce en plastique et la pièce en aluminium pose des problèmes de démontage et de recyclage des pièces ;
- la pièce plastique sert de pièce de structure en étant l'intermédiaire unique entre la pièce en magnésium et la pièce en aluminium, alors que c'est elle qui possède les plus mauvaises performances mécaniques ; on ne profite pas de façon optimale de la rigidité de l'aluminium pour la solidité du boîtier ;
- la pièce en aluminium n'étant pas directement solidaire de la pièce en magnésium, on observe des phénomènes de bâillement lorsque l'on presse sur les parois principales du boîtier, les parois latérales ayant alors tendance à s'écarter dans des directions sensiblement parallèles aux plans définis par les parois principales.

Dans l'état de la technique, on connaît également, notamment, la demande de brevet allemand DE 3708174 (D1) qui décrit un boîtier pour relais électromagnétiques ; le boîtier assure un fermeture d'un boîtier au moyen d'une pluralité de queues d'aronde afin d'éviter un phénomène de bâillement lorsque l'on presse sur le boîtier. La forme générale d'une queue d'aronde est connue et fréquemment utilisée dans différents domaines tels que l'industrie du bois ; celle-ci est à présent décrite en se référant à la figure 2. Une queue d'aronde est un assemblage à tenon 200 et mortaise 201 dont le tenon 200 a une forme trapézoïdale qui lui permet de résister à un arrachement une fois qu'il est disposé dans la mortaise 201.

D1 ne traite cependant pas des téléphones mobiles, et propose une solution uniquement pour assembler deux pièces distinctes, et non pas trois comme c'est le cas dans l'invention. D1 ne présente donc pas de solution pour répondre aux problèmes spécifiques rencontrés dans la réalisation des boîtiers de téléphones mobiles.

EP 0 707 293 A décrit un boîtier pour un détecteur IR assurant l'alignement de deux pièces au moyen de queues d'aronde.

EP 1 331 796 A décrit un boîtier pour téléphone mobile assurant l'alignement de deux pièces au moyen d'éléments de guidage.

DE 201 13 206 U décrit un boîtier pour téléphone mobile constitué de plusieurs pièces.

### DESCRIPTION GENERALE DE L'INVENTION

Le boîtier selon l'invention propose une solution aux problèmes et inconvénients qui viennent d'être exposés. Dans l'invention, on propose un boîtier de téléphone mobile présentant une structure globale similaire à celle de l'état de la technique décrit, c'est à dire avec trois pièces distinctes qui doivent être solidarisées pour constituer un boîtier, mais dont les trois pièces coopèrent toutes les unes avec les autres notamment pour supprimer le phénomène de bâillement qui a été décrit précédemment. La deuxième pièce formant partie centrale du boîtier n'est ainsi plus le seul support des deux autres pièces. Par ailleurs, dans l'invention, on ne procède plus à l'adhésivage de deux pièces entre elles, mais on réalise des liaisons purement mécaniques entre les trois pièces.

A cet effet, dans le boîtier selon l'invention, on propose d'utiliser des queues d'aronde comme moyens essentiels de fermeture du boîtier, ce moyen de fermeture pouvant éventuellement être complété par d'autres moyens de solidarisation. Des tenons de queue d'aronde sont ainsi disposés sur la première pièce formant partie supérieure du boîtier; ils servent tout d'abord à réaliser un pré-maintien de la deuxième pièce formant partie centrale en venant se placer dans des encoches de la deuxième pièce; puis les tenons sont insérés dans des mortaises disposées sur la troisième pièce formant partie inférieure du boîtier, garantissant ainsi la fermeture du boîtier selon l'invention en empêchant les phénomènes de bâillement.

L'invention concerne donc essentiellement un boîtier de téléphone mobile constitué d'une première pièce formant partie supérieure du boîtier, d'une deuxième pièce formant partie centrale du boîtier et d'une troisième pièce formant partie inférieure du boîtier ;
la première pièce présentant une première paroi principale avec une première face supérieure et une première face inférieure, et une première paroi latérale s'étendant perpendiculairement à, et sur au moins une partie d'un contour de, la première face inférieure ;
la deuxième pièce présentant une deuxième paroi principale avec une deuxième face supérieure et une deuxième face inférieure, et une deuxième paroi latérale s'étendant perpendiculairement à, et sur au moins une partie d'un contour de, la deuxième face inférieure;
la troisième pièce présentant une troisième paroi principale avec une troisième face supérieure et une troisième face inférieure, et une troisième paroi latérale s'étendant perpendiculairement à, et à proximité d'au moins une partie d'un contour de, la troisième face supérieure ;
caractérisé en ce que la première pièce et la deuxième pièce sont assemblées au moyen d'au moins un tenon de queue d'aronde, disposé sur la première paroi latérale parallèlement à la première paroi principale, chaque tenon étant placé dans une encoche, qui lui est associée, de la deuxième paroi latérale afin de maintenir la première face inférieure contre la deuxième face supérieure;
et en ce que l'assemblage constitué de la première pièce et de la deuxième pièce est fixé sur la troisième pièce en insérant chaque tenon de queue d'aronde dans une mortaise de queue d'aronde présente au niveau de la troisième paroi latérale pour éviter un mouvement en translation de la première paroi latérale parallèlement à la troisième paroi principale.

Le boîtier de téléphone mobile selon l'invention peut comporter une ou plusieurs caractéristiques supplémentaires, parmi les suivantes:
- la première paroi principale, la deuxième paroi principale et la troisième paroi principale sont de forme rectangulaire ;
- la première paroi latérale comporte six tenons de queues d'aronde ;
- les tenons de queue d'aronde sont disposés symétriquement sur la première paroi latérale ;
- au moins un tenon de queue d'aronde est disposé dans un angle de la première paroi latérale ;
- la troisième paroi principale comporte au moins une ouverture pour introduire, au niveau de la troisième face inférieure, et retenir une vis destinée à être vissée dans une cavité appropriée de la deuxième paroi principale ;
- la première pièce est en aluminium ;
- la deuxième pièce est en plastique ;
- la troisième pièce est en magnésium ;
- le boîtier comporte une charnière, retenue par deux ouvertures, servant de support à un axe de rotation de la charnière, ménagées dans la troisième pièce, pour pouvoir être articulé par rapport à une partie complémentaire dudit boîtier.

L'invention et ses différentes applications seront mieux comprises à la lecture de la description qui suit et à l'examen des figures qui l'accompagnent.

### BREVE DESCRIPTION DES FIGURES

Celles-ci ne sont présentées qu'à titre indicatif et nullement limitatif de l'invention. Les figures montrent :
- à la figure 1, déjà décrite, une représentation schématique d'un téléphone mobile susceptible d'utiliser le boîtier selon l'invention ;
- à la figure 2, également déjà décrite, une illustration d'une queue d'aronde ;
- à la figure 3, une représentation en perspective des différentes pièces constituant le boîtier selon l'invention ;
- à la figure 4, une vue détaillée d'une partie du boîtier selon l'invention.

### DESCRIPTION DES FORMES DE REALISATION PREFEREES DE L'INVENTION

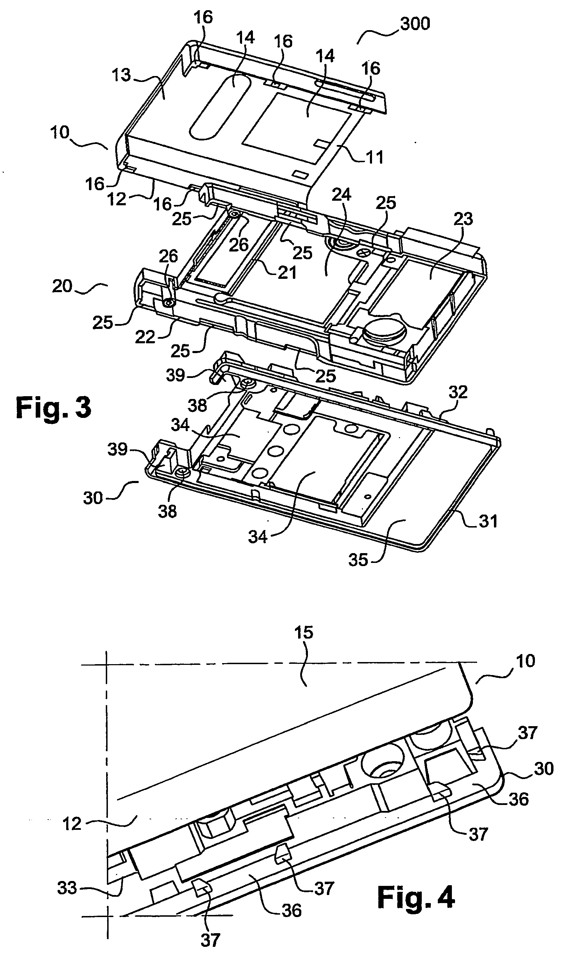

Dans la suite de la description, sauf précision contraire, les éléments apparaissant sur différentes figures conservent les mêmes références. D'une façon générale, on qualifiera de supérieur les éléments orientés vers le haut et on qualifiera d'inférieur les éléments orientés vers le bas selon la disposition représentée à la figure 3.

Sur cette figure, on a représenté un exemple de boîtier 300 selon l'invention, dont les principaux éléments constitutifs ont été séparés pour faciliter la description. Les principaux éléments constitutifs du boîtier 300 selon l'invention sont les suivants :
- une première pièce 10, formant partie supérieure du boîtier 300, réalisée par exemple en aluminium. On repère sur la première pièce 10 une première paroi principale 11 et une première paroi latérale 12 ; dans l'exemple représenté, la première paroi principale 11 est de forme rectangulaire, à l'exception des rebords de cette paroi qui sont arrondis ; elle est plane et présente quelques ouvertures 14 destinées à répondre à des besoins spécifiques du téléphone mobile. Dans d'autres exemples de réalisation du boîtier selon l'invention, la première paroi principale 11 de la première pièce 10 peut prendre toute forme compatible avec une utilisation du boîtier comme coque de téléphone mobile.
   La première paroi latérale 12 est perpendiculaire à la première paroi principale 11 ; elle est disposée le long d'un contour d'une première face inférieure 13. Elle définit ainsi une épaisseur de la première pièce 10. Une première face extérieure 15 de la première paroi principale 11 est visible à la figure 4. La première paroi latérale 12 n'est pas de hauteur constante sur la totalité du contour de la première face inférieure 13. Elle est d'épaisseur constante, à l'exception des endroits ou des tenons 16 de queue d'aronde sont présents : les tenons 16 s'étendent vers l'intérieur du boîtier 300, parallèlement à la première paroi principale 11 ; leur avancée est de l'ordre de quelques millimètres, et leur plus grande dimension est comprise entre 0,5 centimètre et 1 centimètre.
   Dans l'exemple représenté, les tenons 16 sont au nombre de six, dont cinq sont visibles à la figure 3. Ils sont disposés symétriquement sur chaque partie de la première paroi latérale 12 suivant la plus grande dimension du contour de la première face inférieure 13. Deux tenons sont disposés dans des angles de la première paroi latérale 12.
- une deuxième pièce 20, formant partie centrale du boîtier 300, réalisée par exemple en plastique. On repère sur la deuxième pièce 20 une deuxième paroi principale 21 et une deuxième paroi latérale 22 ; dans l'exemple représenté, la deuxième paroi principale 21 est de forme rectangulaire, à l'exception des rebords de cette paroi qui sont arrondis ; elle est approximativement plane, et présente quelques ouvertures 24. Sa forme générale et ses dimensions doivent respecter celle de la première pièce 10 dans laquelle elle doit venir s'encastrer totalement en hauteur et en largeur, et au moins partiellement en longueur.
   La deuxième paroi latérale 22 est perpendiculaire à la deuxième paroi principale 21 ; elle est disposée le long d'un contour d'une deuxième face inférieure 23. Elle définit ainsi une épaisseur de la deuxième pièce 20. La deuxième paroi latérale est d'épaisseur approximativement constante, avec des écarts d'épaisseur n'excédant pas le millimètre
   La deuxième paroi latérale 22 n'est pas de hauteur constante sur la totalité du contour de la deuxième face inférieure 23 ; elle présente notamment des encoches 25 destinées à recevoir les tenons de queue d'aronde 16 lors de l'assemblage de la pièce en aluminium 10 et de la pièce en plastique 20. La deuxième pièce 20 peut ainsi, dans une opération de pré-assemblage du boîtier 300, être retenue entre les tenons 16 et la première face inférieure 13 de la première paroi principale 11. Une deuxième face supérieure, non visible sur les figures, de la pièce en plastique 20 est ainsi mise en contact avec la première face inférieure 13 de la pièce en aluminium 10 ; l'opération d'assemblage de la première et de la deuxième pièce s'effectue en exerçant une légère pression sur la deuxième paroi latérale 22 afin qu'elle puisse franchir l'obstacle constitué par les tenons 16. On profite ici des propriétés élastiques de la matière plastique utilisée pour réaliser la deuxième pièce 20. Une fois cette opération de pré-assemblage effectuée, les tenons 16 empêchent tout mouvement selon un axe perpendiculaire aux parois principales. Les encoches 25 sont cependant prévues suffisamment longues pour qu'un espace subsiste entre les extrémités des tenons 16 et les rebords des encoches 25. Un léger mouvement longitudinal est ainsi possible entre la première pièce 10 et la deuxième pièce 20 après la réalisation de l'assemblage de ces deux pièces.
- une troisième pièce 30, formant partie inférieure du boîtier 300, réalisée par exemple en magnésium. On repère sur la troisième pièce 30 une troisième paroi principale 31 et une troisième paroi latérale 32 ; dans l'exemple représenté, la troisième paroi principale 31 est de forme rectangulaire; elle est approximativement plane, et présente quelques ouvertures 34. Sa forme générale et ses dimensions doivent respecter celles de la première pièce 10 et de la deuxième pièce 20 qu'elle vient compléter pour constituer une coque fermée constituant le boîtier 300.
   La troisième paroi latérale 32 est perpendiculaire à la troisième paroi principale 31 ; elle est disposée à proximité d'un contour d'une troisième face supérieure 33, visible à la figure 4 ; celle-ci est tout particulièrement usinée. Une troisième face inférieure 35 constitue une des deux faces du boîtier 300 qui sera visible par l'utilisateur. Elle peut notamment supporter l'écran LCD.
   La troisième paroi latérale est d'épaisseur et de hauteur variable. Elle présente notamment des mortaises 36, visibles à la figure 4, destinées à recevoir les tenons de queue d'aronde 16 lors de l'assemblage définitif par empilement entre la pièce en magnésium 30 et le pré-assemblage constitué de la pièce en aluminium 10 et de la pièce en plastique 20. Chaque mortaise 36 est constituée de deux parois élémentaires, orientées de telle sorte qu'un assemblage de type queue d'aronde soit réalisé lorsque un des tenons 16 y est placé. Les parois élémentaires ont la forme de petits murets disposés obliquement au niveau de la troisième paroi latérale 32. Les dimensions de ces parois élémentaires 37 sont suffisamment petites pour venir se placer dans l'espace subsistant entre les extrémités des tenons 16 et les rebords des encoches 25 après que l'assemblage entre la pièce en aluminium 10 et la pièce en plastique 20 a été réalisé.
   La pièce en magnésium 30 peut par ailleurs présenter deux cavités 39, servant de support à un axe de rotation d'une charnière de téléphone lorsque celui-ci est un clam.

La présence des fixation en queue d'aronde empêche ainsi les bâillements qui pouvaient être observés dans l'état de la technique. Par ailleurs, pour définitivement sceller le boîtier 300, on peut prévoir de disposer des vis, qui sont introduites dans des ouvertures 38 de la troisième face inférieure 35 de la pièce en magnésium 30, qui sont retenues dans ces ouvertures 38, et qui sont vissées dans des cavités 26, spécifiquement ménagées dans la deuxième face inférieure 23 de la pièce en plastique 20. Chacune des trois pièces est ainsi solidarisée aux deux autres, sans utiliser d'adhésif, soit par fixation en queue d'aronde, soit par pré-assemblage, soit par vissage. Les propriétés particulières de chaque matériau choisi pour ces pièces retrouvent ainsi leur efficacité maximale.

## Revendications

1. Boîtier (300) de téléphone mobile constitué d'une première pièce (10) formant partie supérieure du boîtier, d'une deuxième pièce (20) formant partie centrale du boîtier et d'une troisième pièce (30) formant partie inférieure du boîtier ;
la première pièce (10) présentant une première paroi principale (11) avec une première face supérieure (15) et une première face inférieure (13), et une première paroi latérale (12) s'étendant perpendiculairement à, et sur au moins une partie d'un contour de, la première face inférieure (13);
la deuxième pièce (20) présentant une deuxième paroi principale (21) avec une deuxième face supérieure et une deuxième face inférieure (23), et une deuxième paroi latérale (22) s'étendant perpendiculairement à, et sur au moins une partie d'un contour de, la deuxième face inférieure (23);
la troisième pièce (30) présentant une troisième paroi principale (31) avec une troisième face supérieure (33) et une troisième face inférieure (35), et une troisième paroi latérale (32) s'étendant perpendiculairement à, et à proximité d'au moins une partie d'un contour de, la troisième face supérieure (33);
**caractérisé en ce que** la première pièce (10) et la deuxième pièce (20) sont assemblées au moyen d'au moins un tenon (16) de queue d'aronde, disposé sur la première paroi latérale (12) parallèlement à la première paroi principale (11), chaque tenon (16) étant placé dans une encoche (25) de la deuxième paroi latérale (22) afin de maintenir la première face inférieure (13) contre la deuxième face supérieure;
et **en ce que** l'assemblage constitué de la première pièce (10) et de la deuxième pièce (20) est fixé sur la troisième pièce (30) en insérant chaque tenon (16) de queue d'aronde dans une mortaise (36) de queue d'aronde présente au niveau de la troisième paroi latérale (32) pour éviter un mouvement en translation de la première paroi latérale (12) parallèlement à la troisième paroi principale (11).

2. Boîtier (300) de téléphone mobile selon la revendication précédente **caractérisé en ce que** la première paroi principale (11), la deuxième paroi principale (21) et la troisième paroi principale (31) sont de forme rectangulaire.

3. Boîtier (300) de téléphone mobile selon la revendication précédente **caractérisé en ce que** la première paroi latérale (11) comporte six tenons (16) de queue d'aronde.

4. Boîtier (300) de téléphone mobile selon l'une au moins des revendications précédentes **caractérisé en ce que** les tenons (16) de queue d'aronde sont disposés symétriquement sur la première paroi latérale (12).

5. Boîtier (300) de téléphone mobile selon l'une au moins des revendications précédentes **caractérisé en ce que** au moins un tenon (16) de queue d'aronde est disposé dans un angle de la première paroi latérale (12).

6. Boîtier (300) de téléphone mobile selon l'une au moins des revendications précédentes **caractérisé en ce que** la troisième paroi principale (31) comporte au moins une ouverture (38) pour introduire, au niveau de la troisième face inférieure (35), et retenir une vis destinée à être vissée dans une cavité (26) appropriée de la deuxième paroi principale (21).

7. Boîtier (300) de téléphone mobile selon l'une au moins des revendications précédentes **caractérisé en ce que** la première pièce (10) est en aluminium.

8. Boîtier (300) de téléphone mobile selon l'une au moins des revendications précédentes **caractérisé en ce que** la deuxième pièce (20) est en plastique.

9. Boîtier (300) de téléphone mobile selon l'une au moins des revendications précédentes **caractérisé en ce que** la troisième pièce (30) est en magnésium.

10. Boîtier (300) de téléphone mobile selon l'une au moins des revendications précédentes **caractérisé en ce qu'**il comporte une charnière, retenue par deux cavités (39), servant de support à un axe de rotation de la charnière, ménagées dans la troisième pièce (30), pour pouvoir être articulé par rapport à une partie complémentaire dudit boîtier.

## Claims

1. A case (300) for a mobile telephone comprised of a first piece (10) forming the upper part of the case, a second piece (20) forming the central part of the case and a third piece (30) forming the lower part of the case;
the first piece (10) presenting a first main wall (11) with a first upper face (15) and a first lower face (13), and a first lateral wall (12) extending perpendicularly to, and on at least one part of a contour of, the first lower face (13);
the second piece (20) presenting a second main wall (21) with a second upper face and a second lower face (23), and a second lateral wall (22) extending perpendicularly to, and on at least one part of a contour of, the second lower face (23);
the third piece (30) presenting a third main wall (31) with a third upper face (33) and a third lower face (35), and a third lateral wall (32) extending perpendicularly to, and near at least one part of a contour of, the third upper face (33);
**characterized in that** the first piece (10) and the second piece (20) are assembled by means of at least one tenon (16) of a dovetail, disposed on the first lateral wall (12) parallel to the first main wall (11), each tenon (16) being placed in a slot (25) of the second lateral wall (22) in order to maintain the first lower face (13) against the second upper face;
and **in that** the assembly comprised of the first piece (10) and of the second piece (20) is fixed on the third piece (30) by inserting each dovetail tenon (16) in a dovetail mortise (36) present at the level of the third lateral wall (32) to prevent movement in translation of the first lateral wall (12) parallel to the third main wall (11).

2. The mobile telephone case (300) according to the previous claim **characterized in that** the first main wall (11), the second main wall (21) and the third main wall (31) are in rectangular form.

3. The mobile telephone case (300) according to the previous claim **characterized in that** the first lateral wall (11) comprises six dovetail tenons (16).

4. The mobile telephone case (300) according to at least one of the previous claims **characterized in that** the dovetail tenons (16) are disposed symmetrically on the first lateral wall (12).

5. The mobile telephone case (300) according to at least one of the previous claims **characterized in that** at least one dovetail tenon (16) is disposed in a corner of the first lateral wall (12).

6. The mobile telephone case (300) according to at least one of the previous claims **characterized in that** the third main wall (31) comprises at least one opening (38) to introduce, at the level of the third lower face (35), and to hold, a screw intended to be screwed in a suitable cavity (26) of the second main wall (21).

7. The mobile telephone case (300) according to at least one of the previous claims **characterized in that** the first piece (10) is in aluminum.

8. The mobile telephone case (300) according to at least one of the previous claims **characterized in that** the second piece (20) is in plastic.

9. The mobile telephone case (300) according to at least one of the previous claims **characterized in that** the third piece (30) is in magnesium.

10. The mobile telephone case (300) according to at least one of the previous claims **characterized in that** the case comprises a hinge, held by two cavities (39), used to support an axis of revolution of the hinge, provided in the third piece (30), to be able to be articulated with relation to an additional part of said case.

## Patentansprüche

1. Mobiltelefongehäuse (300), das aus einem ersten Teil (10), der einen oberen Teil des Gehäuses bildet, einen zweiten Teil (20), der den Mittelteil des Gehäuses bildet, und einem dritten Teil (30), der den unteren Teil des Gehäuses bildet, besteht;
wobei der erste Teil (10) eine erste Hauptwand (11) mit einer ersten Oberseite (15) und einer ersten Unterseite (13) und eine erste Seitenwand (12) aufweist, die sich senkrecht zu und auf mindestens einem Teil einer Kontur der ersten Unterseite (13) erstreckt;
wobei der zweite Teil (20) eine zweite Hauptwand (21) mit einer zweiten Oberseite und einer zweiten Unterseite (23) und eine zweite Seitenwand (22) aufweist, die sich senkrecht zu und auf mindestens einem Teil einer Kontur der zweiten Unterseite (23) erstreckt;
wobei der dritte Teil (30) eine dritte Hauptwand (31) mit einer dritten Oberseite (33) und einer dritten Unterseite (35) und eine dritte Seitenwand (32) aufweist, die sich senkrecht zu und mindestens nahe zu einem Teil einer Kontur der dritten Oberseite (33) erstreckt;
**dadurch gekennzeichnet, dass** der erste Teil (10) und der zweite Teil (20) mit Hilfe von mindestens einem schwalbenschwanzförmigen Zapfen (16) zusammengefügt sind, der auf der ersten Seitenwand (12) parallel zur ersten Hauptwand (11) angeordnet ist, wobei jeder Zapfen (16) in einer Kerbe (25) der zweiten Seitenwand (22) angeordnet ist, um die erste Unterseite (13) an der zweiten Oberseite zu halten;
und dass der Zusammenbau aus dem ersten Teil (10) und dem zweiten Teil (20) auf dem dritten Teil (30) befestigt ist, wobei jeder schwalbenschwanzförmige Zapfen (16) in ein schwalbenschwanzförmiges Zapfenloch (36) eingesetzt wird, das im Bereich der dritten Seitenwand (32) vorhanden ist, um eine Translationsbewegung der ersten Seitenwand (12) parallel zur dritten Hauptwand (11) zu verhindern.

2. Mobiltelefongehäuse (300) nach dem vorhergehenden Anspruch, **dadurch gekennzeichnet, dass** die erste Hauptwand (11), die zweite Hauptwand (21) und die dritte Hauptwand (31) rechteckige Form aufweisen.

3. Mobiltelefongehäuse (300) nach dem vorhergehenden Anspruch, **dadurch gekennzeichnet, dass** die erste Seitenwand (11) sechs schwalbenschwanzförmige Zapfen (16) umfasst.

4. Mobiltelefongehäuse (300) nach mindestens einem der vorhergehenden Ansprüche, **dadurch gekennzeichnet, dass** die schwalbenschwanzförmigen Zapfen (16) symmetrisch auf der ersten Seitenwand (12) angeordnet sind.

5. Mobiltelefongehäuse (300) nach mindestens einem der vorhergehenden Ansprüche, **dadurch gekennzeichnet, dass** mindestens ein schwalbenschwanförmiger Zapfen (16) in einem Winkel der ersten Seitenwand (12) angeordnet ist.

6. Mobiltelefongehäuse (300) nach mindestens einem der vorhergehenden Ansprüche, **dadurch gekennzeichnet, dass** die dritte Hauptwand (31) mindestens eine Öffnung (38) umfasst, um im Bereich der dritten Unterseite (35) eine Schraube einzuführen und zu halten, die dazu bestimmt ist, in einen geeigneten Hohlraum (26) der zweiten Hauptwand (21) geschraubt zu werden.

7. Mobiltelefongehäuse (300) nach mindestens einem der vorhergehenden Ansprüche, **dadurch gekennzeichnet, dass** der erste Teil (10) aus Aluminium ist.

8. Mobiltelefongehäuse (300) nach mindestens einem der vorhergehenden Ansprüche, **dadurch gekennzeichnet, dass** der dritte Teil (20) aus Kunststoff ist.

9. Mobiltelefongehäuse (300) nach mindestens einem der vorhergehenden Ansprüche, **dadurch gekennzeichnet, dass** der dritte Tei (30) aus Magnesium ist.

10. Mobiltelefongehäuse (300) nach mindestens einem der vorhergehenden Ansprüche, **dadurch gekennzeichnet, dass** es ein Scharnier umfasst, das von zwei Hohlräumen (39) gehalten wird, die als Stütze für eine Drehachse des Scharniers dienen und in dem dritten Teil (30) vorgesehen sind, um in Bezug zu einem ergänzenden Teil des Gehäuses angelenkt zu werden.
